# EUROPÄISCHE PATENTSCHRIFT

(11) **EP 0 972 340 B1**
(45) Veröffentlichungstag und Bekanntmachung des Hinweises auf die Patenterteilung: **17.10.2001**
(21) Anmeldenummer: 98909333.1
(22) Anmeldetag: 05.02.1998
(51) Int. Cl.: H03G 5/00, H03G 9/00

(54) **VERFAHREN ZUR AUTOMATISCHEN LAUTSTÄRKESTEUERUNG IN EINER AUDIOSIGNAL-WIEDERGABEVORRICHTUNG UND ANORDNUNG DAZU**
AUTOMATIC VOLUME CONTROL IN AN AUDIO-SIGNAL REPRODUCTION FACILITY, AND DEVICE REQUIRED
PROCEDE DE COMMANDE AUTOMATIQUE DU VOLUME DANS UNE INSTALLATION DE REPRODUCTION DE SIGNAUX AUDIO, ET SYSTEME REQUIS A CET EFFET

(30) Priorität: 04.04.1997 DE 19713862
(43) Veröffentlichungstag der Anmeldung: 19.01.2000
(73) Patentinhaber: ROBERT BOSCH GMBH, 70442 Stuttgart (DE)
(72) Erfinder: GLEIM, Peter, D-31199 Diekholzen (DE)
(86) Internationale Anmeldenummer: DE9800315
(87) Internationale Veröffentlichungsnummer: WO9845940

(56) Entgegenhaltungen:
- EP-A- 0 609 665
- AT-B- 397 894
- PATENT ABSTRACTS OF JAPAN vol. 095, no. 001, 28.Februar 1995 & JP 06 284006 A (VICTOR CO OF JAPAN LTD), 7.Oktober 1994,

## Beschreibung

### Stand der Technik

Die Erfindung geht von einem Verfahren zur automatischen Lautstärkesteuerung in einer Audiosignal-Wiedergabevorrichtung sowie einer Anordnung zur Durchführung des Verfahrens gemäß den Oberbegriffen der unabhängigen Ansprüche aus.

Es sind Rundfunkempfänger bekannt, bei denen Endverstärker zur Verstärkung eines wiederzugebenden Audiosignals vorgesehen sind, die über einen Ausgang verfügen, an dem bei Übersteuerung eines Endverstärkers ein eine Übersteuerung anzeigendes Signal ansteht.

Weiterhin sind in dem Prospekt Programm 96/97 der Anmelderin Autoradiogeräte Berlin RCM 303 A und Atlanta RD 105 beschrieben, in denen digitale Signalverarbeitungsschaltungen in Form digitaler Signalprozessoren (DSP) zur automatischen störgeräuschabhängigen Lautstärkesteuerung der wiederzugebenden Audiosignale vorgesehen sind, wobei in Abhängigkeit der Intensität und der spektralen Verteilung des Störgeräusches die Wiedergabelautstärke des Audiosignals frequenzselektiv angehoben wird.

### Vorteile der Erfindung

Die erfindungsgemäße Anordnung mit den Merkmalen des unabhängigen Sachanspruchs hat den Vorteil, daß der beim letztgenannten Stand der Technik ohnehin bereits vorhandene digitale Signalprozessor zusätzlich zur automatischen Lautstärkeregelung zur Verhinderung von Übersteuerungen des Endverstärkers mitverwendbar ist. Auf diese Weise werden ein separater Mikroprozessor sowie ein spezieller elektronisch steuerbarer Lautstärkesteller des erstgenannten Standes der Technik entbehrlich. Außerdem steigt die Reaktionsgeschwindigkeit auf eine Übersteuerung des Endverstärkers erheblich an, in ersten Versuchen wurde eine Verringerung der Reaktionszeit um den Faktor 100 erzielt, so daß eine Übersteuerung praktisch nicht mehr hörbar wird.

Das erfindungsgemäße Verfahren mit den Merkmalen des unabhängigen Verfahrensanspruchs hat zudem den Vorteil, daß durch unterschiedliche Wahl der Werte bei Absenkung und Erhöhung der Wiedergabelautstärke, sowie durch Verzögerung der Erhöhung der Wiedergabelautstärke nach einer Absenkung mittels eines zwischengeschalteten Zählers Regelschwingungen der Lautstärke nicht mehr hörbar sind.

Von Vorteil ist es weiterhin, daß nach Deaktivierung der automatischen Lautstärkeregelung die gegebenenfalls abgesenkte Wiedergabelautstärke nicht schlagartig, sondern allmählich mit der durch das erfindungsgemäße Verfahren vorgegebenen Zeitkonstanten auf den ursprünglich voreingestellten Wert angehoben wird.

Im Rahmen verschiedener Messungen wurde festgestellt, daß beim Auftreten von Übersteuerungen des Endverstärkers in der überwiegenden Zahl der Fälle die tieferfrequenten Audiosignalanteile diese Übersteuerungen verursachen. Es ist daher von Vorteil, nicht das gesamte Audiosignal im Falle einer Übersteuerung zu dämpfen, sondern nur die für die Übersteuerung verantwortlichen niederfrequenten Audiosignalanteile, da eine solche frequenzselektive Lautstärkeabsenkung weniger auffällig ist, als eine Absenkung des gesamten Audiosignalbereichs.

Schließlich wird es als vorteilhaft angesehen, die Dynamik der Lautstärkeregelung durch entsprechende Wahl der Lautstärke- und Zähler- In- und Dekremente an die Dynamik der Signalquelle oder der Signalart anzupassen. So weist beispielsweise das von einer Compakt-Disc (CD) abgespielte Audiosignal einen erheblich höheren Dynamikumfang auf, als beispielsweise ein vom Rundfunkempfänger abgegebenes Audiosignal.

### Zeichnungen

Ausführungsbeispiele der Erfindung sind in den Zeichnungen dargestellt und werden in der Folge näher erläutert.

Es zeigen Figur 1 den erfindungserheblichen Teil einer Audiosignal-Wiedergabevorrichtung für monophone Audiosignale in Form eines Blockschaltbildes, Figur 1a ein Ausführungsbeispiel für die in der digitalen Signalverarbeitungsschaltung der Figur 1 realisierte Schaltung zur Beeinflussung der Wiedergabelautstärke, Figur 1b ein Ausführungsbeispiel einer erfindungsgemäßen Anordnung für die Wiedergabe stereophoner Audiosignale, Figur 2 ein Ablaufdiagramm für das in der digitalen Signalverarbeitungsschaltung realisierte Steuerprogramm und Figur 3 beispielhaft die zeitlichen Abläufe bei der Regelung der Wiedergabelautstärke.

### Beschreibung eines Ausführungsbeispiels

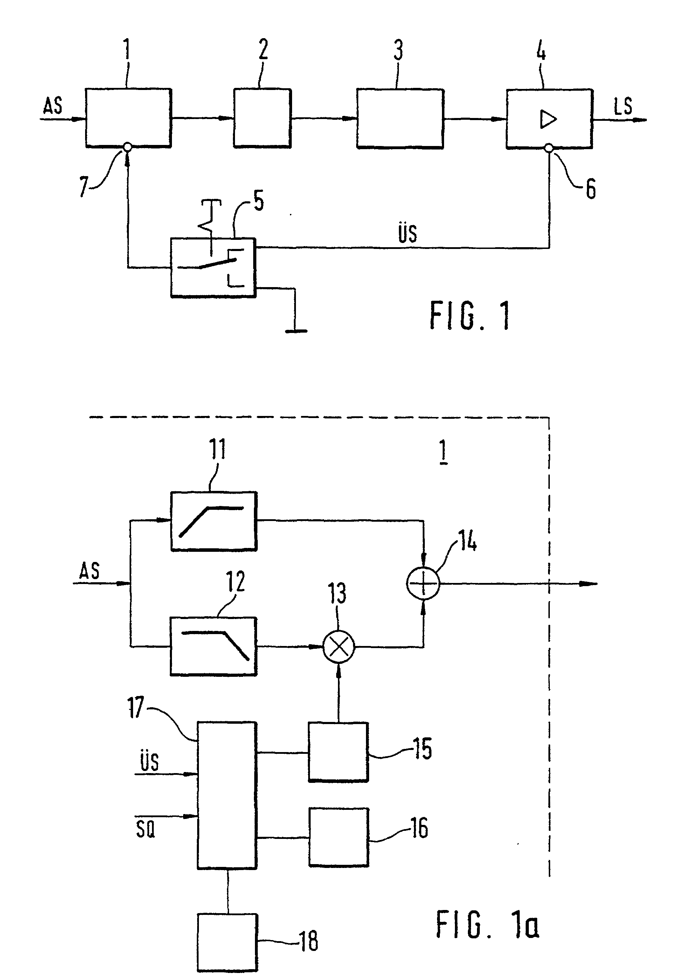

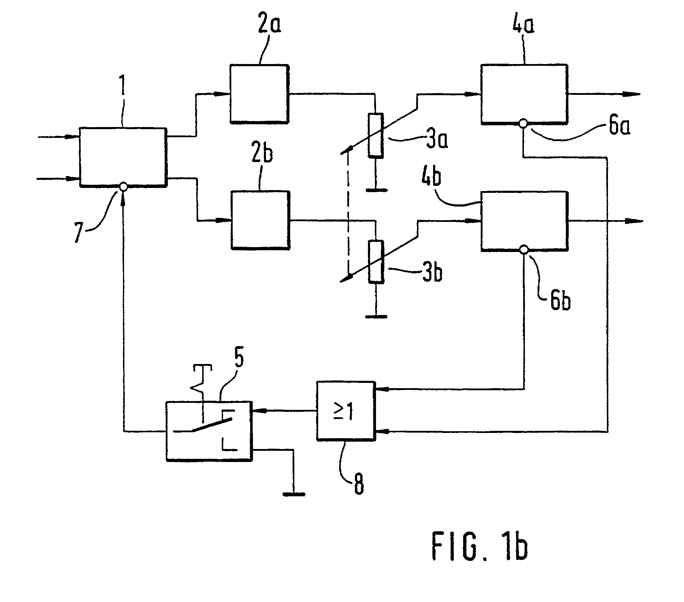

Figur 1 zeigt ein Blockschaltbild des erfindungswesentlichen Teils einer erfindungsgemäßen Audiosignal-Wiedergabevorrichtung für monophone Wiedergabe.

Das in digitaler Form vorliegende wiederzugebende Audiosignal AS ist einer digitalen Signalverarbeitungsschaltung 1 in Form eines digitalen Signalprozessors DSP zur Beeinflussung des Wiedergabesignals zugeführt. Das digitale Ausgangssignal der digitalen Signalverarbeitungsschaltung 1 ist über einen Digital-Analog-Umsetzer 2 einem Lautstärkesteller 3 zur manuellen Voreinstellung der Wiedergabelautstärke des wiederzugebenden Audiosignals zugeführt. Der Ausgang des Lautstärkestellers 3 ist mit einem Endverstärker 4 zur Verstärkung des Wiedergabesignals verbunden, an den wiederum ein nicht dargestellter Lautsprecher zur Wiedergabe des verstärkten Audiosignals LS angeschlossen ist.

Der Endverstärker 4 verfügt über einen Ausgang 6, an dem im Falle der Übersteuerung des Endverstärkers 4 ein eine Übersteuerung anzeigendes Signal ÜS ansteht. Dieser Übersteuerungsausgang 6 des Endverstärkers 4 ist über einen manuell betätigbaren Schalter 5 einem Steuereingang 7 der digitalen Signalverarbeitungsschaltung zugeführt. In einer ersten Schaltstellung des Schalters 5 ist der Übersteuerungsausgang 6 des Endverstärkers 4 mit dem Steuereingang 7 der digitalen Signalverarbeitungsschaltung 1 verbunden, während der Signalweg in einer zweiten Schaltstellung des Schalters 5 unterbrochen, und der Steuereingang der digitalen Signalverarbeitungsschaltung 1 mit einem Bezugspotential verbunden ist.

Durch Umschalten des Schalters 5 von der ersten in die zweite Schaltstellung ist die in der Folge näher beschriebene automatische Regelung der Wiedergabelautstärke deaktivierbar. Alternativ zur Verwendung des Schalters 5 zum Ein- bzw. Ausschalten der Regelung ist es auch vorstellbar, durch Betätigung einer entsprechenden Taste an einer Bedieneinheit der Wiedergabevorrichtung in der digitalen Signalverarbeitungsschaltung 1 ein Register zu setzen, dessen Zustand die Aktivierung oder Deaktivierung des Regelalgorithmus anzeigt.

Ein Blockschaltbild eines bevorzugten Ausführungsbeispiels des erfindungswesentlichen Teils der digitalen Signalverarbeitungsschaltung 1 ist in Figur 1a dargestellt.

Das in digitaler Form vorliegende Audiosignal AS ist sowohl einem Hochpaß 11, wie auch einem Tiefpaß 12 zugeführt, wobei Flankensteilheit und Grenzfrequenz der beiden Filter idealerweise übereinstimmen. Das Ausgangssignal des Tiefpasses 12 ist dem ersten Eingang eines Multiplizierers 13 zur Bewertung mittels eines von einem ersten Zähler 15 bereitgestellten, dem zweiten Eingang des Multiplizierers 13 zugeführten Faktors zugeführt. Zur Bildung des dem Digital-Analog- Umsetzer 2 zugeführten wiederzugebenden Audiosignals sind die Ausgänge des Hochpasses 11 und des Multiplizierers 13 mit den beiden Eingängen eines Addierers 14 verbunden.

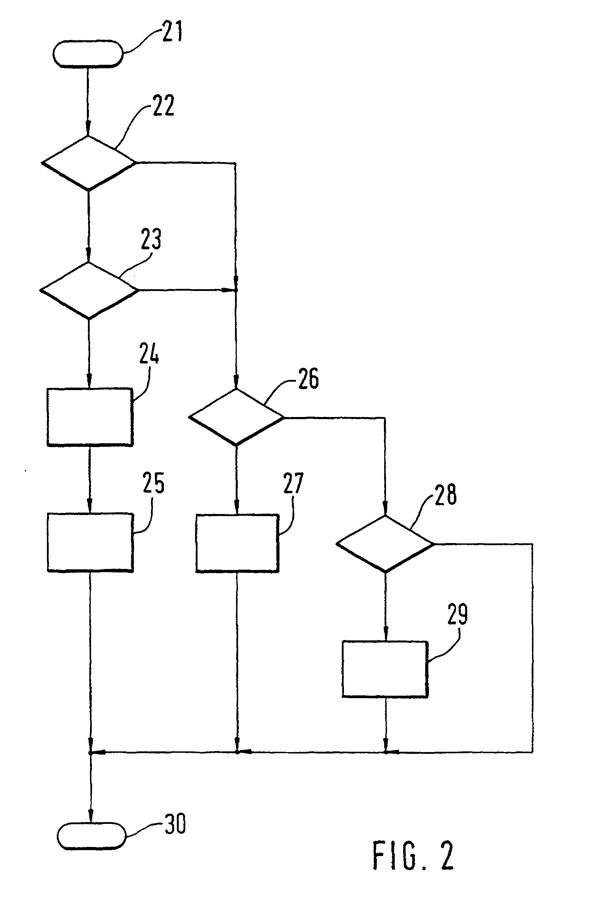

Der erste Zähler 15 zur Bereitstellung eines Faktors zur Absenkung der Wiedergabelautstärke ist ebenso wie ein zweiter Zähler 16 mit einer Steuerung 17 verbunden, in der das in Figur 2 dargestellte Steuerprogramm implementiert ist, und deren Funktionsweise in Verbindung mit der Beschreibung der Funktionsweise des erfindungsgemäßen Verfahrens im Folgenden näher erläutert wird. Außerdem ist die Steuerung 17 mit einem Speicher 18 verbunden, in dem verschiedene Sätze von vorgegebenen Werten abgespeichert sind, die in Abh. eines die gewählten Signalquelle anzeigenden Signals SQ ausgelesen und den Zählern 15, 16 zugeführt werden.

Durch Aufspaltung des wiederzugebenden Audiosignals in einen hochfrequenten und einen niederfrequenten Anteil und gezielte Beeinflussung des niederfrequenten Anteils wird erreicht, daß die erfindungsgemäße Lautstärkeregelung sich nur auf den niederfrequenten Anteil des wiederzugebenden Audiosignals auswirkt.

Der in Figur 2 dargestellte Ablauf wird für jeden Abtastwert des der digitalen Signalverarbeitungsschaltung 1 zugeführten, in digitaler Form vorliegenden Audiosignals aufgerufen und beginnt mit dem Schritt 21. Bei 22 wird abgefragt, ob der Regelungsalgorithmus aktiviert ist, d. h. ob ein entsprechendes Register in der digitalen Signalverarbeitungsschaltung gesetzt ist. Bei dem in Figur 1 dargestellten Ausführungsbeispiel, bei dem zur Deaktivierung des Algorithmus der Schalter 5 in seine zweite Schaltstellung gebracht wird, erübrigt sich diese erste Abfrage 22.

Ist der Regelungsalgorithmus aktiviert, so wird bei 23 der mit dem Übersteuerungsausgang 6 des Endverstärkers 4 verbundene Steuereingang 7 der digitalen Signalverarbeitungsschaltung 1 auf das Vorhandensein eines eine Übersteuerung anzeigenden Signals überprüft. Ist während des letzten Abtastwertes des digitalen Signals eine Übersteuerung aufgetreten, oder tritt diese während der Abfrage 23 auf, so wird der Zählerstand eines ersten Zählers 15 und damit die Lautstärke L des wiederzugebenden Audiosignals, das mit dem Zählerstand des ersten Zählers 15 multipliziert wird, um einen ersten vorgegebenen Wert in der Größenordnung von im vorliegenden Fall 1/1000 des Maximalwertes 1 erniedrigt (Schritt 24). Gleichzeitig wird der Zählerstand Z des zweiten Zählers 16 ausgehend vom Wert 0 um einen zweiten vorgegebenen Wert, im vorliegenden Fall um 1, erhöht (Schritt 25). Anschließend wird der Ablauf bei 30 beendet.

Für den Fall, daß der Regelalgorithmus durch Rücksetzen des entsprechenden Registers in der digitalen Signalverarbeitungsschaltung 1 oder, wie in Figur 1 dargestellt durch Betätigung des Schalters 5 in seine zweite Schaltstellung deaktiviert ist, oder, wie bei 23 abgefragt, keine Übersteuerung des Endverstärkers 4 aufgetreten ist, wird bei 24 der Zählerstand Z des zweiten Zählers 16 abgefragt. Ist dieser ungleich, also größer 0, so wird der Zählerstand des zweiten Zählers 16 bei 27 um einen dritten vorgegebenen Wert, der im vorliegenden Fall in der Größenordnung von 1/10 des zweiten vorgegebenen Werts gewählt ist, dekrementiert und der Ablauf bei 30 beendet.

Ist der Zählerstand Z des zweiten Zählers 16 gleich 0, so wird bei 28 überprüft, ob die Wiedergabelautstärke L gegenüber dem voreingestellten Wert L₀ reduziert, also der Zählerstand des ersten Zählers 15 kleiner als 1 ist. Ist dies der Fall, so wird der Zählerstand des ersten Zählers 15 und damit die Wiedergabelautstärke L um einen vierten vorgegebenen Wert angehoben (Schritt 29) und das Verfahren beendet, während für den Fall, daß die Lautstärke L nicht reduziert ist, der Ablauf bei 30 ohne weitere Aktion abgeschlossen wird.

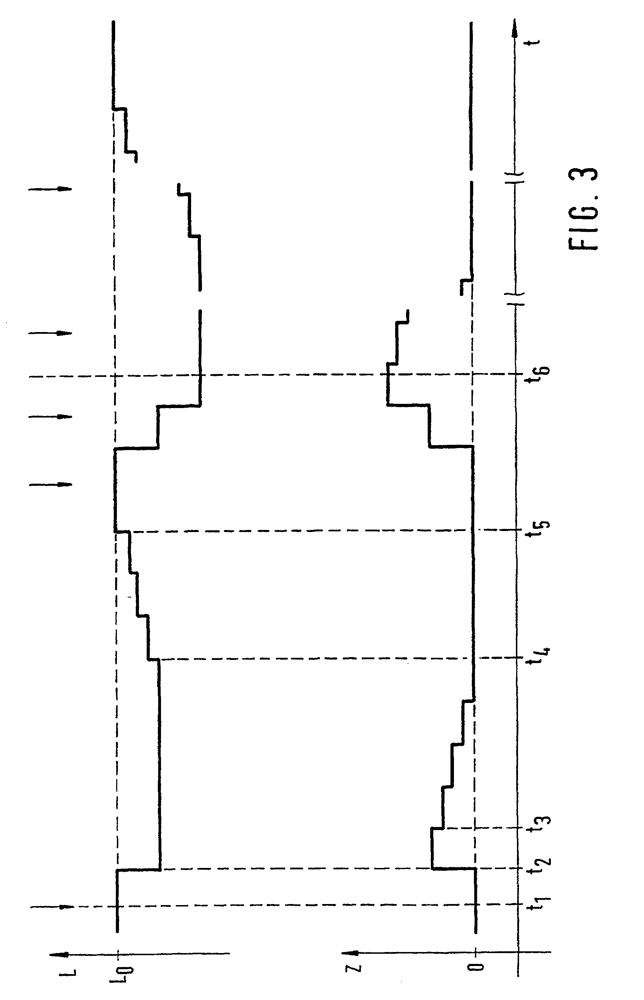

In Figur 3 sind der Ablauf des erfindungsgemäßen Verfahrens und die Funktionsweise der erfindungsgemäßen Anordnung anhand des zeitlichen Verlaufs der Wiedergabelautstärke L und des Zählerstandes Z des zweiten Zählers 16 nochmals verdeutlicht.

Die Wiedergabelautstärke befindet sich zunächst auf dem über den Lautstärkesteller 3 voreingestellten Wert L₀, der Zählerstand des zweiten Zählers 16 ist 0. Außerdem befindet sich der Schalter 5 in seiner ersten Schaltstellung, d. h. der Regelalgorithmus ist aktiviert.

Zum Zeitpunkt t₁ tritt nun eine am oberen Bildrand als Pfeil dargestellte Übersteuerung des Endverstärkers 4 auf. Mit Beginn des nächsten Abtastwertes des Audiosignals, also beim vorliegenden Beispiel zum Zeitpunkt t₂ wird der Ablauf gemäß Figur 2 gestartet. Da wie bei 22 abgefragt wird, die Regelung aktiv ist, wird infolge des Vorliegens einer Übersteuerung des Endverstärkers 4 bei 24 die Wiedergabelautstärke des Audiosignals um den ersten vorgegebenen Wert reduziert und gleichzeitig der zweite Zähler 16 um den zweiten vorgegebenen Wert erhöht. Zum Zeitpunkt t₃ wird infolge des Fehlens einer Übersteuerung des Endverstärkers 4 der zweite Zähler um den dritten vorgegebenen Wert, der für das vorliegende Beispiel zu 1/4 des zweiten vorgegebenen Werts gewählt wurde, dekrementiert. Dieser Vorgang wird wegen des Fehlens einer weiteren Übersteuerung solange wiederholt, bis der zweite Zähler 16 den Wert 0 erreicht hat.

Zum Zeitpunkt t₄ wird, da der Zählerstand des zweiten Zählers 0 ist und keine weitere Übersteuerung vorliegt, die Wiedergabelautstärke um den vierten vorgegebenen Wert erhöht, der im vorliegenden Beispiel zu 1/4 des ersten vorgegebenen Werts gewählt ist. In Abwesenheit weiterer Übersteuerungen wird die Lautstärke so lange schrittweise erhöht, bis sie bei t₅ ihren ursprünglichen Wert L₀ erreicht hat.

Zum Zeitpunkt t₆, zu dem die Regelung durch Betätigung des Schalters 5 in die zweite Schaltstellung abgeschaltet wird, sind die Lautstärke infolge des Vorangehens zweier Übersteuerungszustände reduziert und der Zählerstand des zweiten Zählers 16 erhöht. Trotz weiterer Übersteuerungszustände wird nun der Zählerstand des zweiten Zählers 16 schrittweise bis auf 0 dekrementiert und anschließend die Wiedergabelautstärke schrittweise auf den voreingestellten Wert L₀ angehoben.

In Figur 1b ist ein zweites Ausführungsbeispiel für eine Anordnung zur Durchführung des erfindungsgemäßen Verfahrens für die Wiedergabe stereophoner Audiosignale dargestellt. Dieses weist zwei Signalpfade 2a bis 4a und 2b bis 4b für die Signale des linken und des rechten Audiokanals auf. Die durch eine, beispielsweise mechanische Kopplung gleichzeitig betätigten Lautstärkesteller 3a und 3b sind in Form einseitig mit dem Bezugspotential verbundener Potentiometer, die mit den Ausgängen der Digital-Analog-Umsetzer 2a und 2b verbunden sind, und deren Abgriffe den Endverstärkern 4a und 4b zugeführt sind, ausgeführt.

Die Übersteuerungsausgänge der Endverstärker 4a und 4b sind in einer Oder-Schaltung 8 zu einem gemeinsamen Übersteuerungssignal ÜS zusammengefaßt, das über den Schalter 5 dem Steuereingang 7 der digitalen Signalverarbeitungsschaltung 1 zugeführt ist, die im vorliegenden Fall für jeden der beiden Stereokanäle jeweils eine der Anordnungen 11 bis 14 und zur Betätigung der Anordnungen 11 bis 14 eine gemeinsame Anordnung 15 bis 18 enthält.

Bei einer Weiterbildung des erfindungsgemäßen Verfahrens ist es vorgesehen, daß die Höhe der vorgegebenen Werte in Abhängigkeit der Signalquelle, von der das wiederzugebende Audiosignal zur Verfügung gestellt wird, gewählt werden. So wird beispielsweise für von einer Kompaktdisk stammende Audiosignale eine höhere Regeldynamik, d. h. höhere dritte und vierte vorgegebene Werte gewählt, als für Rundfunksignale, da die Audiosignale von CD eine höhere Dynamik aufweisen.

Dazu ist mit der Steuerung 17 ein Speicher 18 mit mehreren Sätzen von vorgegebenen Werten verbunden, aus dem ein einer bestimmten Signalquelle zugeordneter Wertesatz ausgelesen wird. Dies ist im vorliegenden Fall durch Adressierung des Speichers mittels des Quellenwahlschalters, der der Auswahl der an die Wiedergabevorrichtung angeschlossenen Signalquelle dient, realisiert.

In ähnlicher Weise können verschiedenen Signalarten, z. B. klassischer oder Popmusik unterschiedliche Sätze vorgegebener Werte zugeordnet werden. Im Falle von Rundfunksignalen ist eine Unterscheidung der Signalart, z. B. durch Auswertung der über das Radio- Daten- System (RDS) ausgestrahlten Programmart-Kennung (PTY) möglich, die anzeigt, welche Programmart von einem Rundfunksender aktuell ausgestrahlt wird.

## Patentansprüche

1. Verfahren zur automatischen Lautstärkeregelung in einer Audiosignal-Wiedergabevorrichtung mit mindestens einem Endverstärker zur Verstärkung eines wiederzugebenden Audiosignals, insbesondere in einem Autoradio, zur Reduzierung von Übersteuerungen des mindestens einen Endverstärkers, wobei der mindestens eine Endverstärker im Falle einer Übersteuerung ein eine Übersteuerung anzeigendes Signal erzeugt, **dadurch gekennzeichnet, daß** bei Auftreten eines eine Übersteuerung anzeigenden Signals (ÜS) die Wiedergabelautstärke (L) des Audiosignals (AS) um einen ersten vorgegebenen Wert vermindert und gleichzeitig der Zählerstand (Z) eines Zählers (16) um einen zweiten vorgegebenen Wert erhöht wird, daß bei Ausbleiben eines eine Übersteuerung anzeigenden Signals (ÜS) der Zählerstand (Z) um einen dritten vorgegebenen Wert vermindert wird, solange der Zählerstand (Z) größer null ist, und die Wiedergabelautstärke (L) um einen vierten vorgegebenen Wert angehoben wird, sofern der Zählerstand (Z) null und die Wiedergabelautstärke(L) kleiner als ein voreingestellter Wert (L₀) ist, und daß die beschriebenen Verfahrensschritte für jeden Abtastwert des in digitaler Form vorliegenden Audiosignals (AS) wiederholt werden.

2. Verfahren nach Anspruch 1, **dadurch gekennzeichnet, daß** für den Fall, daß die Lautstärkeregelung deaktiviert worden ist, der Zählerstand um den dritten vorgegebenen Wert vermindert wird, solange der Zählerstand(Z) größer null ist, und die Wiedergabelautstärke (L) um den vierten vorgegebenen Wert angehoben wird, sofern der Zählerstand (Z) null und die Wiedergabelautstärke (L) kleiner als ein voreingestellter Wert (L₀)ist, und daß die beschriebenen Verfahrensschritte für jeden Abtastwert (AS) des Audiosignals wiederholt werden.

3. Verfahren nach einem der Ansprüche 1 oder 2, **dadurch gekennzeichnet, daß** der erste vorgegebene Wert größer als der vierte vorgegebene Wert und der zweite vorgegebene Wert größer als der dritte vorgegebene Wert ist.

4. Verfahren nach einem der Ansprüche 1 bis 3, **dadurch gekennzeichnet, daß** die Beeinflussung der Wiedergabelautstärke (L) frequenzselektiv, vorzugsweise nur im niederfrequenten Audiosignalbereich, erfolgt.

5. Verfahren nach einem der Ansprüche 1 bis 4, **dadurch gekennzeichnet, daß** die vorgegebenen Werte in Abhängigkeit der gewählten Audiosignalquelle und/oder der Art des wiederzugebenden Audiosignals (AS) aus einer Menge von vorgegebenen Werten ausgewählt werden.

6. Anordnung zur automatischen Lautstärkeregelung in einer Audiosignal-Wiedergabevorrichtung mit mindestens einem Endverstärker (4), dem ein wiederzugebendes Audiosignal zugeführt ist, und der über einen Übersteuerungsausgang (6) zur Abgabe eines eine Übersteuerung anzeigenden Signals (ÜS) verfügt, **dadurch gekennzeichnet, daß** der Übersteuerungsausgang (6) des Endverstärkers (4) mit einem Steuereingang (7) einer digitalen Signalverarbeitungsschaltung (1) zur Beeinflussung der Wiedergabelautstärke in Abhängigkeit des eine Übersteuerung anzeigenden Signals (ÜS) verbunden ist,
daß die Signalverarbeitungsschaltung (1) eine Steuerung (17) umfaßt, die derart ausgeführt ist, daß bei Anstehen eines eine Übersteuerung anzeigenden Signals (ÜS) am Steuereingang (7) die Wiedergabelautstärke (L) des Audiosignals (AS) mit Mitteln (13, 15) um einen ersten vorgegebenen Wert vermindert und gleichzeitig der Zählerstand (Z) eines Zählers (16) um einen zweiten vorgegebenen Wert erhöht wird, daß bei Ausbleiben eines eine Übersteuerung anzeigenden Signals (ÜS) am Steuereingang (7) der Zählerstand (Z) des Zählers (16) um einen dritten vorgegebenen Wert vermindert wird, solange der Zählerstand (Z) größer null ist, und die Wiedergabelautstärke (L) mit Mitteln (13, 15) um einen vierten vorgegebenen Wert angehoben wird, sofern der Zählerstand (Z) null und die Wiedergabelautstärke(L) kleiner als ein voreingestellter Wert (L₀) ist, und daß die beschriebenen Schritte für jeden Abtastwert des in digitaler Form vorliegenden Audiosignals (AS) wiederholt werden.

7. Anordnung nach Anspruch 6, **dadurch gekennzeichnet, daß** zum Ausschalten der Lautstärkeregelung die Verbindung des Übersteuerungsausgangs (6) des mindestens einen Endverstärkers (4) mit dem Eingang (7) der digitalen Signalverarbeitungsschaltung (1) durch einen Schalter (5) unterbrechbar ist.

8. Anordnung nach Anspruch 6 oder 7, **dadurch gekennzeichnet, daß** die Lautstärkeregelung in Form von Software in der digitalen Signalverarbeitungsschaltung (1) realisiert ist.

9. Anordnung nach einem der Ansprüche 6 bis 8, **dadurch gekennzeichnet, daß** ein Speicher (18) vorgesehen ist, in dem die in Abhängigkeit der gewählten Signalquelle (SQ) und/oder Signalart aufgerufenen vorgegebenen Werte abgelegt sind.

## Claims

1. Method for automatic volume control in an audio signal playback apparatus having at least one output amplifier for amplifying an audio signal which is to be played back, particularly in a car radio, in order to reduce overloading of the at least one output amplifier, where the at least one output amplifier produces a signal which indicates overloading in the event of overloading, **characterized in that**, when a signal (ÜS) which indicates overloading appears, the playback volume (L) of the audio signal (AS) is reduced by a first prescribed value, and the counter reading (Z) of a counter (16) is increased by a second prescribed value at the same time, **in that**, when no signal (ÜS) which indicates overloading appears, the counter reading (Z) is reduced by a third prescribed value for as long as the counter reading (Z) is greater than zero, and the playback volume (L) is increased by a fourth prescribed value provided that the counter reading (Z) is zero and the playback volume (L) is less than a preset value (L₀), and **in that** the method steps described are repeated for each sample of the audio signal (AS) present in digital form.

2. Method according to Claim 1, **characterized in that**, if volume control has been deactivated, the counter reading is reduced by the third prescribed value for as long as the counter reading (Z) is greater than zero, and the playback volume (L) is increased by the fourth prescribed value provided that the counter reading (Z) is zero and the playback volume (L) is less than a preset value (L₀), and **in that** the method steps described are repeated for each sample (AS) of the audio signal.

3. Method according to one of Claims 1 or 2, **characterized in that** the first prescribed value is greater than the fourth prescribed value, and the second prescribed value is greater than the third prescribed value.

4. Method according to one of Claims 1 to 3, **characterized in that** the playback volume (L) is influenced on a frequency-selective basis, preferably only in the audio-frequency audio signal range.

5. Method according to one of Claims 1 to 4, **characterized in that** the prescribed values are selected from a quantity of prescribed values on the basis of the chosen audio signal source and/or the type of audio signal (AS) which is to be played back.

6. Arrangement for automatic volume control in an audio signal playback apparatus having at least one output amplifier (4), to which an audio signal which is to be played back is supplied and which has an overload output (6) for outputting a signal (ÜS) which indicates overloading, **characterized in that** the overload output (6) of the output amplifier (4) is connected to a control input (7) of a digital signal processing circuit (1) for influencing the playback volume on the basis of the signal (ÜS) which indicates overloading, **in that** the signal processing circuit (1) comprises a controller (17) which is designed such that, when a signal (ÜS) which indicates overloading is applied to the control input (7), the playback volume (L) of the audio signal (AS) is reduced by a first prescribed value using means (13, 15), and the counter reading (Z) of a counter (16) is increased by a second prescribed value at the same time, **in that**, if no signal (US) which indicates overloading appears at the control input (7), the counter reading (Z) of the counter (16) is reduced by a third prescribed value for as long as the counter reading (Z) is greater than zero, and the playback volume (L) is increased by a fourth prescribed value using means (13, 15) provided that the counter reading (Z) is zero and the playback volume (L) is less than a preset value (L₀), and **in that** the steps described are repeated for each sample of the audio signal (AS) present in digital form.

7. Arrangement according to Claim 6, **characterized in that**, to turn off volume control, the connection between the overload output (6) of the at least one output amplifier (4) and the input (7) of the digital signal processing circuit (1) can be interrupted by a switch (5).

8. Arrangement according to Claim 6 or 7, **characterized in that** the volume control is provided in the form of software in the digital signal processing circuit (1).

9. Arrangement according to one of Claims 6 to 8, **characterized in that** a memory (18) is provided which stores the prescribed values called on the basis of the chosen signal source (SQ) and/or signal type.

## Revendications

1. Procédé de régulation automatique du volume d'un dispositif de reproduction de signaux audio avec au moins un amplificateur de puissance pour amplifier le signal audio à reproduire notamment un autoradio, pour réduire les sur-régulations d'au moins un amplificateur de puissance, qui en cas de sur-régulation génère un signal indiquant la sur-régulation,
**caractérisé en ce que**
- lorsque se produit un signal indiquant une sur-régulation (ÜS), on diminue le niveau sonore (L) de reproduction du signal audio (AS) d'une première valeur prédéterminée et en même temps on augmente l'état de comptage (Z) d'un compteur (16) d'une seconde valeur prédéterminée,
- en l'absence de signal (ÜS) indiquant une sur-régulation, on diminue l'état de comptage (Z) d'une troisième valeur prédéterminée, aussi longtemps que l'état de comptage (Z) est supérieur à zéro, et on relève le niveau de reproduction (L) d'une quatrième valeur prédéterminée tant que l'état de comptage (Z) est égal à zéro et que le niveau sonore de reproduction (L) est inférieur à une valeur préréglée (L₀), et
- on répète les étapes de procédé décrites pour chaque valeur de détection du signal audio (AS) sous forme numérique.

2. Procédé selon la revendication 1,
**caractérisé en ce qu'**
- au cas où la régulation du volume sonore a été désactivée, on diminue l'état de comptage d'une troisième valeur prédéterminée aussi longtemps que l'état de comptage (Z) est supérieur à zéro, et on relève le niveau sonore de reproduction (L) d'une quatrième valeur prédéterminée dans la mesure où l'état de comptage (Z) est égal à zéro et le volume de reproduction (L) est inférieur à une valeur (L₀) préréglée, et
- on répète les étapes de procédé décrites pour chaque valeur de détection (AS) du signal audio.

3. Procédé selon l'une quelconque des revendications 1 ou 2,
**caractérisé en ce que**
la première valeur prédéterminée est supérieure à la quatrième valeur prédéterminée et la seconde valeur prédéterminée est supérieure à la troisième valeur prédéterminée.

4. Procédé selon l'une quelconque des revendications 1 à 3,
**caractérisé en ce qu'**
on influence le niveau sonore de reproduction (L), de manière sélective en fréquence de préférence seulement dans la plage des basses fréquences du signal audio.

5. Procédé selon l'une quelconque des revendications 1 à 4,
**caractérisé en ce qu'**
on sélectionne des valeurs prédéterminées en fonction de la source de signaux audio choisie et/ou de la nature du signal audio à reproduire (AS) à partir d'un ensemble de valeurs prédéterminées.

6. Dispositif de régulation automatique du volume sonore d'un dispositif de reproduction de signaux audio comprenant au moins un amplificateur de puissance (4) recevant un signal audio à reproduire et qui fournit par une sortie de sur-régulation (6) un signal (ÜS) indiquant une sur-régulation,
**caractérisé en ce que**
- la sortie de sur-régulation (6) de l'amplificateur de puissance (4) est reliée à une entrée de commande (7) d'un circuit numérique de traitement de signal (1), pour influencer l'intensité de reproduction sonore en fonction du signal (ÜS) indiquant une sur-régulation,
- le circuit de traitement de signal (1) comporte une commande (17) telle que lorsqu'un signal (ÜS) indiquant une sur-régulation apparaît à l'entrée de commande (7), le volume sonore de reproduction (L) du signal audio (AS) est diminué par des moyens (13, 15) d'une première valeur prédéterminée, et en même temps l'état de comptage (Z) d'un compteur (16) est augmenté d'une seconde valeur prédéterminée,
- en l'absence d'un signal (ÜS) indiquant une sur-régulation à l'entrée de commande (7), l'état de comptage (Z) du compteur (16) est diminué d'une troisième valeur prédéterminée aussi longtemps que l'état de comptage (Z) est supérieur à zéro, et le volume sonore de reproduction (L) est relevé par les moyens (13, 15) d'une quatrième valeur prédéterminée dans la mesure où l'état de comptage (Z) est égal à zéro et le niveau sonore de reproduction (L) est inférieur à une valeur (L₀) préréglée, et
- les étapes décrites sont répétées pour chaque valeur de détection du signal audio (AS) sous forme numérique.

7. Dispositif selon la revendication 6,
**caractérisé en ce que**
pour couper la régulation de volume sonore, on coupe la liaison entre la sortie de sur-régulation (6) d'au moins un amplificateur de puissance (4) et l'entrée (7) du circuit numérique de traitement de signal (1), à l'aide d'un commutateur (5).

8. Dispositif selon l'une quelconque des revendications 6 ou 7,
**caractérisé en ce qu'**
on réalise la régulation du volume sonore sous la forme de programmes dans le circuit de traitement numérique de signal (1).

9. Dispositif selon l'une quelconque des revendications 6 à 8,
**caractérisé par**
une mémoire (18) contenant des valeurs prédéterminées appelées en fonction de la source de signal (SQ) choisie et/ou de la nature du signal choisie.
